# FASCICULE DE BREVET EUROPEEN

(11) **EP 0 562 905 B1**
(45) Date de publication et mention de la délivrance du brevet: **02.07.1997**
(21) Numéro de dépôt: 93400644.6
(22) Date de dépôt: 12.03.1993
(51) Int. Cl.: H03K 5/13

(54) **Circuit à retard variable**
Schaltung mit veränderlicher Verzögerung
Variable delay circuit

(30) Priorité: 24.03.1992 FR 9203527
(43) Date de publication de la demande: 29.09.1993
(73) Titulaire: BULL S.A., 78430 Louveciennes (FR)
(72) Inventeur: Marbot, Roland, F-78000 Versailles (FR); Cofler, Andrew, F-75015 Paris (FR); Combes, Michel, F-75015 Paris (FR); Lebihan, Jean-Claude, F-92120 Montrouge (FR); Nezamzadeh-Moosavi, Reza, F-78390 Bois d'Arcy (FR)
(74) Mandataire: Colombe, Michel

(56) Documents cités:
- EP-A- 0 253 914
- EP-A- 0 306 662
- EP-A- 0 347 983
- DE-A- 3 839 888
- PATENT ABSTRACTS OF JAPAN vol. 10, no. 213 (E-422)(2269) 25 Juillet 1986;& JP-A-6152022
- EP-A 0 390 226
- U.Tietze, Ch. Schenk, "Halbleiter-Schaltungstechnik", SpringerVerlag Berlin Heidelberg New York Tokyo, figures 24.1 à 24.6
- Funkschau 1976, Heft 21, pages 71,72,77,78
- Funkschau 1976, Heft 23,pages 81,82,87,88

## Description

L'invention concerne les circuits à retard réglable en fonction d'une consigne de retard pouvant être sous la forme d'une grandeur numérique.

Les circuits à retard réglable ont de nombreuses applications et sont notamment utilisés lorsqu'on veut ajuster la phase entre deux signaux logiques. Dans ce cas, le premier de ces signaux est appliqué à l'entrée d'un circuit à retard et la mesure du déphasage entre le signal de sortie et le signal d'entrée sert à commander le réglage du circuit à retard.

L'asservissement de phase peut être réalisé au moyen d'un signal de réglage analogique ou numérique, la solution numérique étant souvent préférée car elle est moins sensible aux perturbations et aux atténuations dues à la transmission des signaux. De plus, dans le cas d'une réalisation sous forme de circuit intégré, elle est moins sensible aux dispersions de fabrication.

Une première solution connue pour réaliser un circuit à retard à commande numérique consiste à utiliser une pluralité de portes élémentaires, par exemple du type inverseur, associées à un système d'interconnexion commandé numériquement et permettant le branchement en cascade d'un nombre variable de portes élémentaires. L'application de ce type de circuit est cependant limitée au cas où il n'est pas nécessaire d'obtenir une précision de réglage du retard inférieure au retard intrinsèque de la porte élémentaire.

Une autre solution connue consiste à utiliser un circuit du type résistance-capacité où la résistance est constituée d'une pluralité de résistances élémentaires branchées sélectivement en parallèle en fonction de la commande numérique. Dans ce cas, le retard est fixé par la constante de temps du circuit. Si toutes les résistances élémentaires ont la même valeur, le retard obtenu est alors inversement proportionnel au nombre de résistances sélectionnées. Or, pour obtenir une précision de réglage constante sur toute la plage de réglage, il est nécessaire que la fonction liant le retard à la grandeur numérique de réglage s'approche le plus possible d'une fonction linéaire. La réponse obtenue par la solution précédente est donc très éloignée de la relation linéaire. Pour s'en rapprocher, il est alors nécessaire de dimensionner les résistances élémentaires à des valeurs bien précises et toutes différentes entre elles. Ce résultat est cependant très difficile à obtenir dans le cas d'une réalisation intégrée. D'autre part, il faudra prévoir un tel circuit pour chaque signal que l'on veut ajuster en phase.

Si par exemple le circuit à retard est destiné à être utilisé dans un circuit verrouillé en phase du type décrit dans la demande de brevet européen publiée sous le numéro 441 684, déposée le 30 janvier 1991 et intitulée "Circuit verrouillé en phase et multiplieur de fréquence en résultant", la solution précédente n'est pas satisfaisante à cause de son encombrement et de sa sensibilité aux dispersions de fabrication.

Le document EP-A 0 306 662 divulgue un circuit conforme au préambule de la revendication 1.

L'invention a pour but de proposer un circuit à retard permettant un réglage précis avec la possibilité d'obtenir un retard minimal inférieur au retard intrinsèque des portes élémentaires pour la technologie choisie, tout en assurant avec une approximation suffisante une réponse linéaire du retard en fonction de la consigne de retard.

Dans ce but, l'invention a pour objet un circuit à retard fournissant un signal de sortie présentant un retard par rapport à un signal logique d'entrée, ledit retard étant réglable en fonction d'une consigne de retard, ledit circuit étant caractérisé en ce qu'il comporte un circuit à retard fixe recevant ledit signal d'entrée et fournissant un signal retardé présentant un retard fixe par rapport audit signal d'entrée et un circuit de combinaison à deux entrées recevant respectivement ledit signal d'entrée et ledit signal retardé et comportant une entrée de commande recevant une grandeur de commande représentative de ladite consigne, ledit circuit de combinaison étant conçu de façon à fournir en sortie un signal de combinaison résultant de la superposition avec pondération et effet intégral des signaux appliqués sur ses entrées, ladite pondération consistant à affecter deux coefficients de pondération associés respectivement au signal d'entrée et au signal retardé dont les valeurs sont fonction de ladite grandeur de commande et en ce que ledit circuit de combinaison et/ou ledit circuit à retard fixe sont dimensionnés de sorte que ledit retard fixe soit inférieur au temps de transition que présente le signal de combinaison lorsque le circuit de combinaison reçoit seulement le signal d'entrée.

Le signal de combinaison fourni par le circuit de combinaison est normalement destiné à être appliqué à l'entrée d'un circuit, tel qu'un circuit de mise en forme, présentant un effet de seuil. Ainsi, le retard effectif du signal de sortie par rapport au signal d'entrée sera donc dépendant du niveau de seuil d'entrée de ces circuits. Il est donc souhaitable que les amplitudes maximum et minimum du signal de combinaison soient indépendantes de la consigne de retard.

Dans ce but, l'invention est en outre caractérisé en ce que la somme des deux coefficients de pondération est constante.

En pratique, l'effet intégral sera produit par un intégrateur ou un circuit à constante de temps présentant toujours un effet de saturation définissant les niveaux extrêmes du signal de combinaison. Le temps de transition sera donc défini comme l'intervalle de temps pendant lequel le signal de combinaison varie selon une fonction linéaire ou quasi linéaire lorsque le circuit de combinaison reçoit seulement le signal d'entrée. Le fait d'imposer un retard fixe inférieur au temps de transition assure que le retard du signal de sortie par rapport au signal d'entrée ne présente pas de discontinuité en fonction des coefficients de pondération. Pour que la variation du retard en fonction de la consigne de retard varie sur toute la plage de réglage selon une fonction pratiquement linéaire de la consigne, le circuit de combinaison et/ou le circuit à retard fixe pourront être dimensionnés de façon à ce que le retard fixe soit égal à la moitié du temps de transition.

L'invention a également pour objet plusieurs modes de réalisation spécialement conçus pour pouvoir utiliser les technologies ECL et CMOS.

Ces réalisations ainsi que d'autres aspects et avantages de l'invention apparaîtront dans la suite de la description en référence aux figures.
- La figure 1 représente le schéma de principe du circuit à retard conforme à l'invention.
- La figure 2 représente des chronogrammes permettant d'expliquer le fonctionnement du circuit de la figure 1.
- Les figures 3 à 6 représentent les variations du retard en fonction de la consigne de retard pour différents dimensionnements du circuit de la figure 1.
- La figure 7 représente le schéma de principe d'une réalisation ECL de circuit à retard qui n'est pas revendiqué.
- Les figures 8 à 10 représentent une réalisation détaillée en technologie ECL.
- La figure 11 représente le schéma de principe d'une réalisation CMOS.
- La figure 12 représente une réalisation détaillée en technologie CMOS.

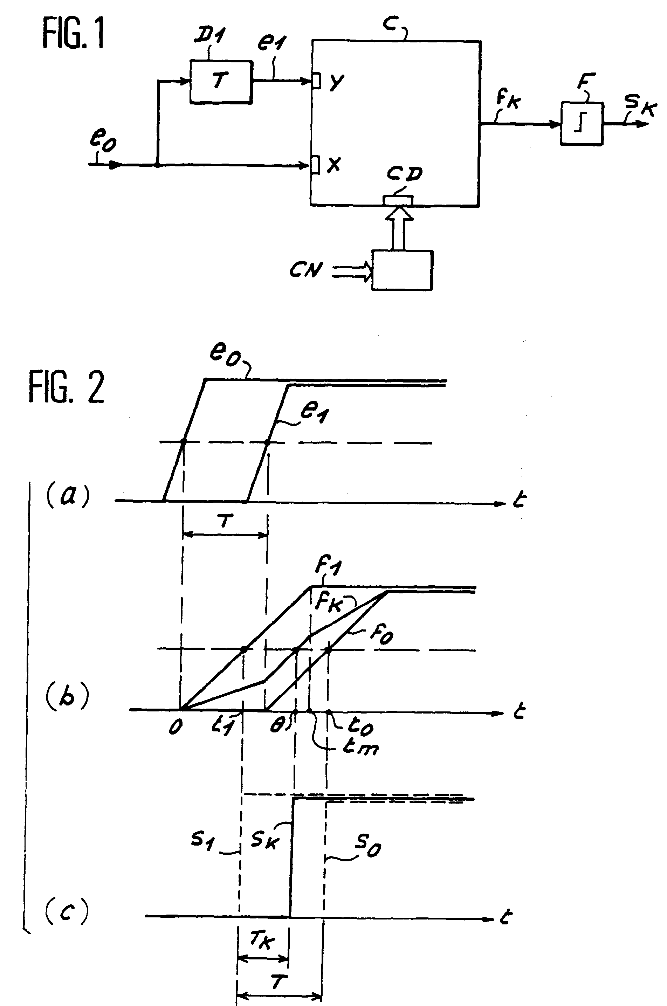

Le circuit à retard selon l'invention est représenté schématiquement à la figure 1. Un circuit à retard fixe D1 reçoit le signal logique d'entrée e₀ et fournit en sortie le signal retardé e₁. Les signaux e₀ et e₁ sont appliqués respectivement aux entrées X et Y d'un circuit de combinaison C fournissant en sortie le signal de combinaison f_{K}. Le circuit de combinaison C comporte une entrée de commande CD recevant une commande représentative des coefficients de pondération de la combinaison effectuée par le circuit C. Cette commande est fonction de la consigne de retard CN.

Le signal de combinaison f_{K} est appliqué à l'entrée d'un circuit de mise en forme F dont la sortie fournit le signal de sortie s_{K}.

Pour simplifier la suite de l'exposé, nous raisonnerons sur les grandeurs normalisées des signaux impliqués et on supposera que les coefficients de pondération affectés aux signaux e₀ et e₁ ont respectivement les valeurs K et 1 - K, avec K compris entre 0 et 1.

Dans ces conditions, le circuit C est conçu pour réaliser la combinaison Ke₀ + (1 - K)e₁ avec intégration par rapport au temps.

Les chronogrammes représentés à la figure 2 permettent d'expliquer le fonctionnement du circuit de la figure 1.

Le chronogramme (a) représente les signaux e₀ et e₁ appliqués aux entrées X et Y du circuit de combinaison C. Le signal e₀ étant un signal logique, il présente un front raide de transition entre un premier et un second niveau qui est suivi d'un autre front (non représenté) rétablissant le signal à son premier niveau. Le signal retardé e₁ a été représenté comme un signal identique à e₀ mais retardé du retard T défini par le circuit à retard D1. En pratique, le front du signal e₀ est défini par l'instant où le signal e₀ atteint une valeur de seuil du circuit aval. En général, la valeur de seuil correspond au niveau intermédiaire entre les niveaux minimum et maximum du signal e₀. Il en est de même pour le signal e₁ et dans ce cas, ce signal pourrait avoir une forme différente de celle représentée, le retard T étant défini alors comme l'intervalle de temps séparant les instants où le signal e₀ et le signal e₁ atteignent la valeur de seuil.

Le chronogramme (b) représente le signal de combinaison f_{K} pour différentes valeurs du coefficient de pondération K. Bien entendu, la forme des signaux représentés est une représentation simplifiée des signaux que l'on peut obtenir avec des circuits réels.

Il convient toutefois de noter que cette représentation n'est pas éloignée de la réalité. En particulier, on observera toujours un palier de saturation car l'intégrale d'une impulsion finit de toute façon par être limitée aux valeurs des potentiels d'alimentation.

Le signal f₁ correspond au cas où K = 1, c'est-à-dire lorsque le coefficient de pondération appliqué au signal e₁ est nul. Ce signal a la forme d'un trapèze dont le front montant débute à l'instant 0 correspondant à l'instant où le signal e₀ atteint la valeur de seuil. Le signal f₁ augmente de façon linéaire jusqu'à l'instant tm où il atteint un palier de saturation.

Le signal f₀ correspond au cas où le coefficient de pondération K appliqué au signal e₀ est nul. Ce signal reproduit le signal f₁ avec le retard T.

Pour des coefficients de pondération différents de ces deux cas extrêmes, le signal de combinaison a l'allure représentée par la courbe f_{K}.

Les signaux f₁ et f₀ atteignent la valeur de seuil respectivement aux instants t1 et t0 tandis que le signal f_{K} atteint ce seuil à l'instant θ. L'écart entre t1 et t0 est égal au retard T. Ainsi, les retards respectivement minimum et maximum du signal de combinaison par rapport au signal d'entrée sont compris entre respectivement t1 et t0. Par conséquent, le retard obtenu dans le cas général aura une valeur θ comprise entre t1 et t1 + T.

Le chronogramme (c) représente le signal de sortie du circuit de mise en forme F dans chacun des trois cas représentés sur le chronogramme (b). Ainsi, les signaux s₁ et s₀ présentent un front respectivement aux instants t1 et t0. Pour un coefficient K donné, le signal de sortie s_{K} possèdera un front retardé d'une valeur T_{K} par rapport au signal s₁, la valeur T_{K} étant comprise entre 0 et T.

La façon dont le retard θ varie en fonction du coefficient de pondération K dépend essentiellement du temps de transition tm défini ci-dessus et du retard fixe T. Le temps de transition tm définira le retard minimum t1 du signal de sortie s_{K} par rapport au signal d'entrée e₀. Dans le cas parfaitement linéaire tel que représenté, ce retard minimum est égal à la moitié du temps de transition.

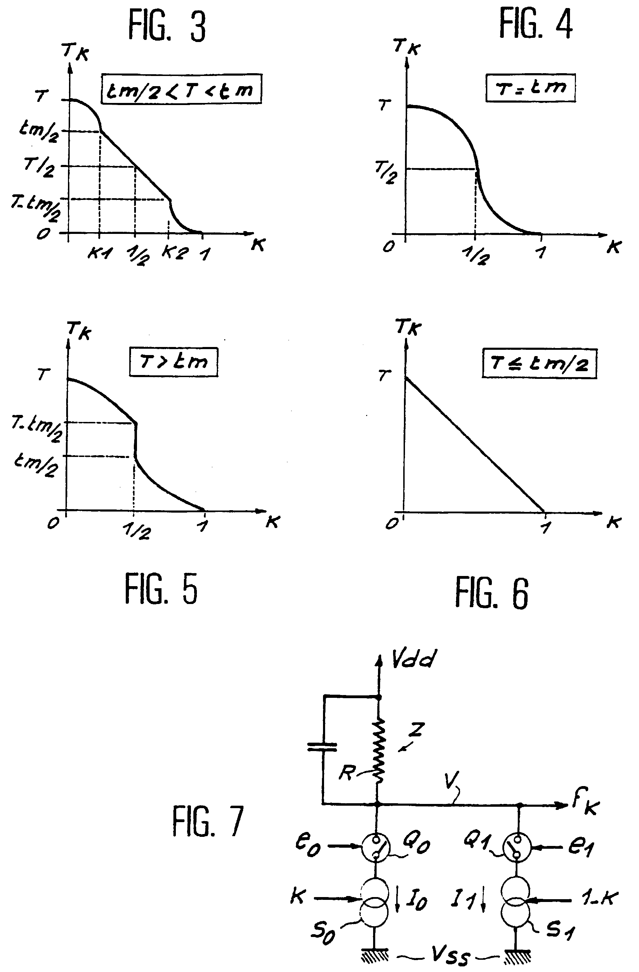

Les figures 3 à 6 représentent les variations du retard T_{K} en fonction du coefficient K pour différentes valeurs du temps de transition tm, le retard fixe T étant supposé fixé.

La figure 3 correspond au cas où T est compris entre le temps de transition tm et la moitié de ce temps, conformément à l'exemple de la figure 2.

Pour K compris entre 0 et une première valeur K1, T_{K} varie entre T et tm/2 selon une fonction hyperbolique. Pour K compris entre la première valeur K1 et une seconde valeur K2, T_{K} varie linéairement entre tm/2 et T - tm/2. Enfin, pour K compris entre K2 et 1, T_{K} varie entre T - tm/2 et 0 selon une autre fonction hyperbolique.

Le calcul permet de vérifier facilement ce résultat et de montrer que K1 = 1 - tm/2T et K2 = tm/2T. Il est également facile de vérifier que l'on a toujours T_{K} = T/2 lorsque K = 1/2.

Lorsque T = tm, T_{K} varie en fonction de K selon la courbe représentée à la figure 4. On peut facilement vérifier que la courbe obtenue est constituée de deux morceaux d'hyperbole et que la partie linéaire est absente.

Si T est supérieur à tm, comme représenté sur la figure 5, la courbe présente une discontinuité pour K = 1/2.

Enfin, si T est inférieur ou égal à tm/2, T_{K} varie linéairement en fonction de K sur toute la plage de réglage comme on peut le voir sur la figure 6.

L'analyse précédente permet de tirer quelques conclusions concernant le dimensionnement à apporter au circuit à retard fixe et au circuit de combinaison. Il apparaît tout d'abord que T doit être inféfieur à tm pour éviter toute discontinuité du retard T_{K} en fonction du coefficient de pondération K donc de la consigne de retard. D'autre part, on obtient une réponse parfaitement linéaire du retard T_{K} en fonction de K dès que T est inférieur ou égal à tm/2. Ainsi, pour tm fixé, on obtiendra une réponse linéaire tout en ayant la plus grande plage de réglage lorsque T est égal à tm/2.

Le retard fixe T détermine la plage de réglage du retard. Aussi pour une plage déterminée, il sera toujours possible d'obtenir une réponse linéaire en choisissant tm = 2T. On pourra cependant être amené à choisir un temps de transition inférieur afin de réduire le retard minimal t1 qui dépend directement du temps de transition tm.

D'une façon générale, le choix de T et de tm résultera d'un compromis entre le retard minimal, la plage de réglage et la linéarité du retard par rapport à la consigne de retard.

La figure 7 représente le schéma de principe du circuit de combinaison C en vue d'une réalisation en technologie ECL.

Le circuit représenté est alimenté par deux potentiels d'alimentation Vdd et Vss correspondant respectivement à un potentiel positif et la masse. Une impédance Z formée d'une résistance R et d'une capacité en parallèle a une première borne reliée au potentiel positif Vdd et une seconde borne reliée à deux sources de courant S0 et S1 par l'intermédiaire respectivement de deux interrupteurs Q0 et Q1. Les interrupteurs Q0 et Q1 sont commandés respectivement par les signaux e₀ et e₁. Les sources de courant S0 et S1 sont des sources de courant réglables commandées respectivement par les coefficients de pondération K et 1 - K et fournissent respectivement des courants I0 et I1 complémentaires et proportionnels aux coefficients de pondération correspondants.

Ce montage réalise donc une superposition des courants I0 et I1 dans l'impédance Z dont la capacité est responsable de l'effet d'intégration.

Le potentiel V de la seconde borne constitue la mesure du signal de combinaison f_{K} et la constante de temps de l'impédance Z permettra de définir le temps de transition tm.

Le fonctionnement du circuit de la figure 7 peut être expliqué à l'aide des chronogrammes de la figure 2. Dans la suite de l'exposé, on utilisera la logique positive et on supposera que les interrupteurs sont ouverts ou fermés selon que les signaux qui les commandent sont respectivement à 0 ou à 1.

Initialement, jusqu'à l'instant 0, les signaux e₀ et e₁ étant à 0, le potentiel V est égal à Vdd. Lorsque e₀ passe à 1, l'interrupteur Q0 se ferme et un courant I0 = KI circule dans l'impédance Z. Le potentiel V diminue alors, avec la constante de temps de l'impédance Z, vers la valeur Vdd - KRI pendant une durée égale au retard fixe T. e₁ passe alors à 1, Q1 se ferme et un courant (1 - K)I s'ajoute au courant KI dans l'impédance Z. Le potentiel V continue donc à diminuer vers la valeur Vdd - RI avec la même constante de temps.

Par la suite, e₀ repasse à 0 et Q0 s'ouvre. Le potentiel V remonte alors vers Vdd - (1 - K)RI pendant la durée T avec la même constante de temps. Enfin, e₁ repasse à 0, Q₁ s'ouvre et le potentiel V continue à monter vers VDD.

Le circuit effectue donc la superposition avec effet intégral des grandeurs Ke₀ et (1 - K)e₁. Bien entendu, les signaux f₁, f₀ et f_{K} présentent en réalité des variations plus progressives que celles représentées sur la figure 2(b), notamment au voisinage du palier de saturation. Cette différence ne modifie toutefois pas substantiellement le résultat obtenu si on définit le temps de transition tm comme l'intervalle de temps pendant lequel les signaux f₁ et f₀ varient pratiquement linéairement en fonction du temps.

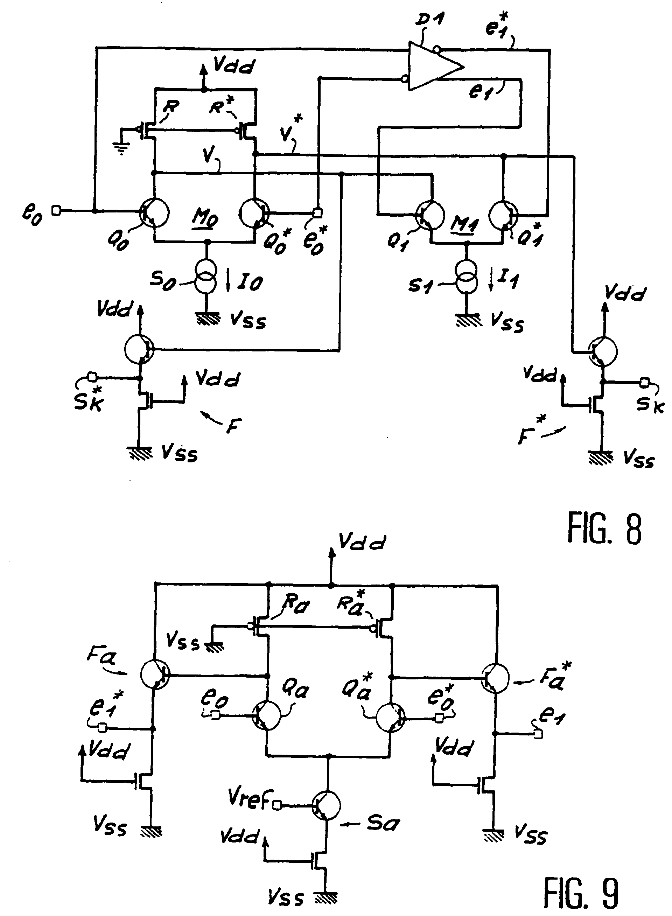

La figure 8 représente une réalisation ECL du circuit de combinaison C. Ce circuit comporte deux résistances R, R* de même valeur, par exemple réalisées au moyen de transistors MOS, ayant chacune une première borne reliée au potentiel d'alimentation Vdd. Une première et une seconde source de courant S0, S1 délivrent respectivement des courants I0, I1 respectivement proportionnels aux coefficients K et 1 - K. Un premier montage différentiel M0 est formé de deux transistors bipolaires Q0, Q0* dont les collecteurs sont reliés respectivement à la deuxième borne des résistances R et R* et dont les émetteurs sont reliés à la source de courant S0. Un second montage différentiel M1 identique à M0 est formé des transistors bipolaires Q1 et Q1* dont les collecteurs sont reliés respectivement à la deuxième borne des résistances R et R* et dont les émetteurs sont reliés à la seconde source de courant S1.

Le signal d'entrée est un signal différentiel e₀, e₀* commandant les bases des transistors Q0 et Q0*. Le signal différentiel e₀, e₀* est d'autre part appliqué à l'entrée d'un amplificateur différentiel D1 jouant le rôle de circuit à retard fixe. L'amplificateur D1 fournit un signal différentiel retardé e1, e1* commandant les bases des transistors Q1 et Q1*. La tension différentielle V, V* entre les deuxièmes bornes des résistances R et R* constitue la mesure du signal de combinaison. Deux montages émetteurs-suiveurs F, F* sont commandés par le signal de combinaison différentiel V, V* et fournissent en sortie un signal de sortie différentiel s_{K}, s_{K}*.

Le fonctionnement du circuit de la figure 8 se déduit aisément de celui de la figure 7 à la différence près que les signaux sont de type différentiel. Il convient toutefois de noter que l'impédance Z de la figure 7 est formée pour chaque voie de la résistance R ou R* et de l'ensemble des capacités qui sont reliées à la résistance telles que les capacités collecteur-base des transistors bipolaires. Dans le cas où les résistances R et R* sont formées de transistors MOS, il conviendra également de tenir compte des capacités drain-grille de ces transistors.

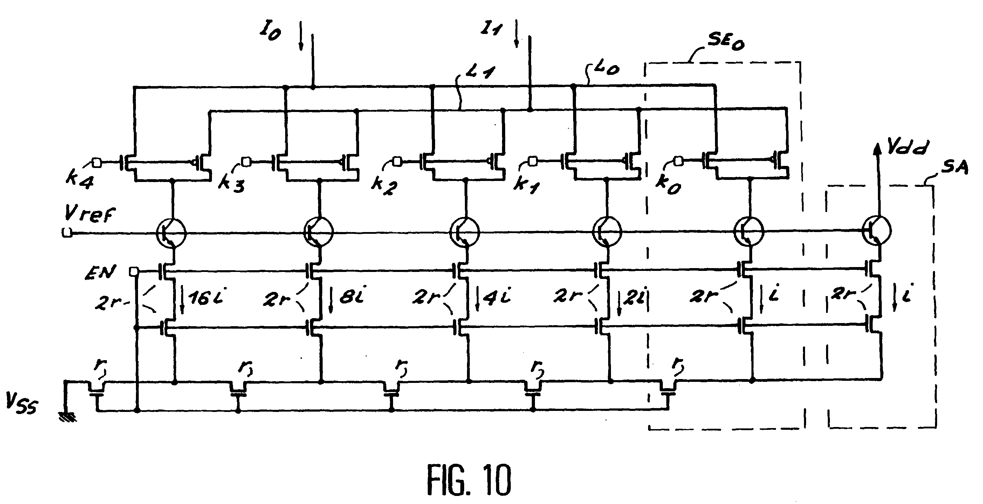

L'amplificateur différentiel D1 est un amplificateur ECL de type classique tel que représenté à la figure 9. Il est constitué pour chaque voie d'une résistance Ra, Ra* dont une première borne est reliée au potentiel Vdd et dont la seconde borne est reliée au collecteur d'un transistor bipolaire Qa, Qa*. Les émetteurs des transistors Qa, Qa* sont reliés à une source de courant Sa dimensionnée pour fournir un courant égal à la valeur maximale I du courant fourni par les sources S0 et S1. Le circuit est complété par deux émetteurs-suiveurs Fa, Fa* dont les entrées sont reliées respectivement aux deuxièmes bornes des résistances Ra, Ra*. Les sorties des émetteurs-suiveurs Fa, Fa* fournissent le signal différentiel retardé e₁, e₁*.

On peut constater que ce circuit introduit un retard défini par la constante de temps due pour chaque voie à la résistance Ra, Ra* et aux capacités des transistors reliés à la résistance. Par conséquent, si les résistances Ra et Ra* ont la même valeur que les résistances R et R* et si les transistors de l'amplificateur ont le même dimensionnement que ceux des montages homologues du circuit de combinaison, on est assuré que le retard fixe de l'amplificateur sera toujours inférieur au temps de transition du circuit de combinaison.

On pourra bien sûr calculer le dimensionnement des composants des circuits (largeur des transistors) en vue d'ajuster le retard fixe T et le temps de transition tm à des valeurs choisies, par exemple pour vérifier T = tm/2. On pourra aussi prévoir un circuit à retard fixe supplémentaire branché en aval de D1 et un autre montage différentiel branché en parralèle à M0 et M1, alimenté par une autre source de courant et commandé par le circuit à retard supplémentaire en vue d'ajouter une gamme de réglage. Dans ce cas, en faisant le bilan des transistors impliqués, on peut vérifier que la capacité équivalente, donc la constante de temps du circuit de la figure 8 est voisine du double de celle de la figure 9, ce qui réalise automatiquement la condition optimale T = tm/2.

La figure 10 représente un circuit permettant de réaliser les deux sources de courant variable S0 et S1.

Selon cette réalisation, le coefficient K est sous forme numérique représentée par les cinq signaux k0 à k4, k0 correspondant au bit de poids faible. Dans ce cas, K peut donc prendre 32 valeurs différentes réparties uniformément entre 0 et 1 (à un coefficient multiplicateur près).

Bien entendu, les réalisations pour un nombre quelconque de bits seront facilement déduites de ce cas particulier.

Le circuit comporte un premier et un second ensemble de résistances respectivement de valeur r et 2r. Les résistances r sont ici réalisées au moyen de transistors MOS à canal n et les résistances 2r sont formées par deux transistors MOS à canal n de même dimension branchés en série. Tous ces transistors MOS ont leur grille polarisée par la tension EN qui les place en régime saturé.

Le circuit comporte un premier sous-ensemble SA comprenant un transistor bipolaire dont le collecteur est relié au potentiel Vdd, dont l'émetteur est relié à une première borne d'une résistance 2r et dont la base reçoit une tension de polarisation Vref.

Un second sous-ensemble SEO comporte un autre transistor bipolaire dont la base reçoit la même tension de polarisation Vref et dont l'émetteur est relié à une première borne d'une autre résistance 2r dont la seconde borne est reliée à la seconde borne de la résistance 2r du sous-ensemble SA ainsi qu'à une première borne d'une résistance r. Le collecteur du transistor bipolaire est relié à deux lignes L0 et L1 par l'intermédiaire respectivement d'un transistor MOS à canal n et d'un transistor MOS à canal p dont les grilles reçoivent le signal k0.

Le circuit comporte quatre autres sous-ensembles (non référencés) identiques à SEO et dont les transistors MOS reçoivent sur leurs grilles respectivement les signaux k1 à k4. Ces quatre sous-ensembles sont montés de la façon indiquée à la figure 10.

Les lignes L0 et L1 sont reliée respectivement aux modules M0 et M1 de la figure 8.

Il est facile de vérifier que le circuit de la figure 10 délivre des courants I0 et I1 respectivement proportionnels à K et 1 - K.

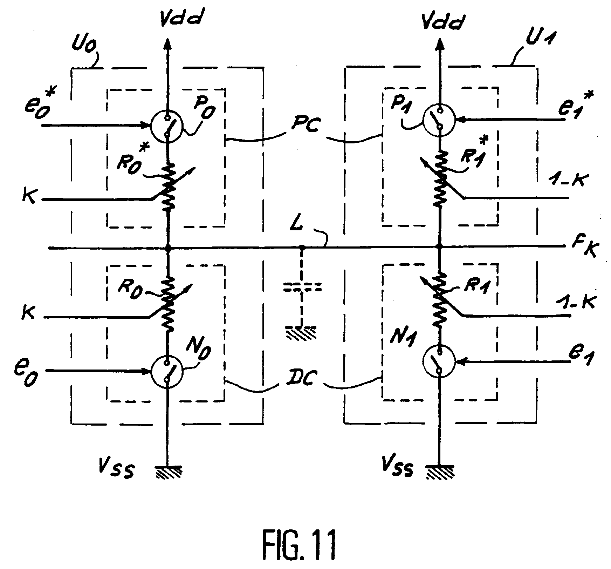

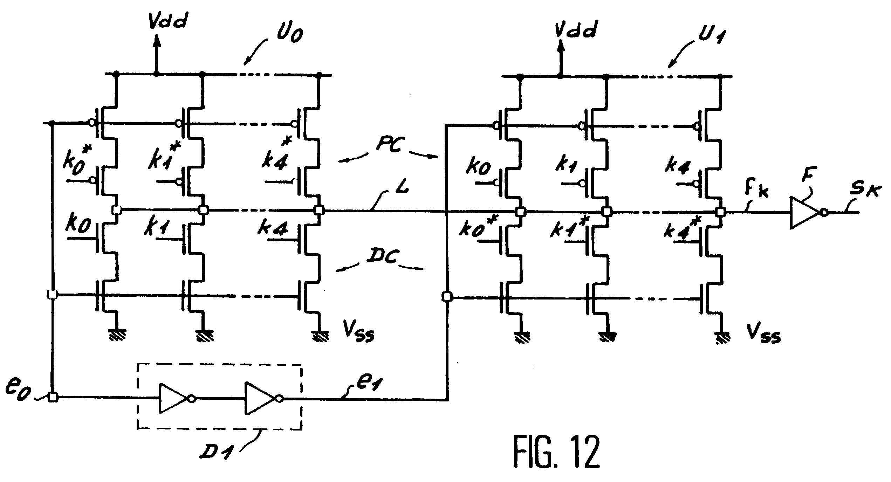

Les figures 11 et 12 concernent une autre réalisation en technologie CMOS du circuit de combinaison C.

La figure 11 est la représentation schématique d'une réalisation CMOS permettant de faciliter sa compréhension. Le circuit comporte un premier et un second module de charge et décharge U0, U1 d'une ligne commune L. Chaque module U0, U1 comporte un circuit de charge PC et un circuit de décharge DC. Chaque circuit de charge PC ou de décharge DC comporte une résistance variable R0*, R0, R1*, R1 et un interrupteur P0, N0, P1, N1 contrôlant la connexion par cette résistance entre la ligne L et le potentiel d'alimentation Vdd pour le circuit de charge et Vss pour le circuit de décharge. Les interrupteurs des unités U0 et U1 sont commandés respectivement par les signaux e₀ et e₁ et leurs compléments. Les résistances variables R0, R0* sont commandées de façon à prendre une valeur inversement proportionnelle au coefficient K tandis que les résistances R1, R1* de l'unité U1 sont commandées de façon à prendre une valeur inversement proportionnelle à 1 - K. Le potentiel de la ligne L constitue la mesure du signal de combinaison f_{K}.

Pour expliquer le fonctionnement du circuit de la figure 11, nous supposerons qu'initialement la ligne L est chargée au potentiel Vdd et que les signaux e₀ et e₁ sont à 0. Les interrupteurs P0 et P1 sont alors fermés tandis que les interrupteurs N0 et N1 sont ouverts. Lorsque le signal e₀ devient actif, l'interrupteur N0 se ferme et l'interrupteur P0 s'ouvre. Le circuit présente alors une constante de temps défini par la capacité de structure au niveau de la ligne L et une résistance équivalente aux résistances R0 et R1* montées en parallèle. Comme R0 et R1* sont inversement proportionnelles à respectivement K et 1 -K, la constante de temps est indépendante de K. La ligne L va alors se décharger avec cette constante de temps depuis la valeur Vdd vers la valeur (1 - K) Vdd.

La décharge se poursuit de cette façon jusqu'à l'instant où le signal e₁ devient actif. Dès lors, l'interrupteur N1 se ferme et l'interrupteur P1 s'ouvre. La ligne L va alors continuer à se décharger vers 0 avec la même constante de temps que précédemment.

Lorsque le signal e₀ redevient inactif, l'interrupteur P0 se ferme et l'interrupteur N0 s'ouvre, ce qui rétablit un circuit de charge de la ligne L vers la tension K Vdd. Lorsque e₁ redevient inactif, on se retrouve dans la situation initiale.

On peut vérifier que le comportement du circuit de la figure 11 est identique du point de vue retard à celui de la réalisation ECL.

La figure 12 représente la réalisation CMOS détaillée correspondant au circuit de la figure 11. Les circuits de charge PC et de décharge DC sont constitués de transistors MOS respectivement à canal p et n. Les résistances variables R0, ..., R1* sont réalisées au moyen de transistors MOS branchés en parallèle et commandés par les signaux k0, ..., k4, k0*, ..., k4*, les interrupteurs associés étant constitués par les chemins drain-source de transistors MOS dont les grilles reçoivent le signal associé e₀, e₁ .

Le circuit à retard fixe est réalisé au moyen de deux inverseurs CMOS en cascade.

La capacité de structure définissant la constante de temps est due aux capacités drain-grille des transistors MOS actifs reliés à la ligne L. De par la conception du circuit, la capacité résultante reste constante, indépendamment de la valeur de K.

D'autre part, les transistors MOS constituant les résistances variables de chaque circuit de charge ou de décharge peuvent être dimensionnés de façon à ce que leurs résistances varient selon une puissance de 2, selon les poids des signaux de commande de k0, ..., k4, ..., k0*, ..., K4*.

Une autre possibilité consiste à remplacer les transistors de dimensionnement variable par des montages parallèle et série de transistors identiques.

Le fonctionnement du circuit de la figure 12 est dans son principe identique à celui de la figure 11 et ne nécessite donc pas d'explications supplémentaires.

## Revendications

1. Circuit à retard pour fournir un signal de sortie (s_{K}) présentant un retard (θ) par rapport à un signal logique d'entrée (e₀), ledit retard (θ) étant réglable en fonction d'une consigne de retard (CN), ledit circuit comportant un circuit à retard fixe (D1) recevant ledit signal d'entrée (e₀) et fournissant un signal retardé (e₁) présentant un retard fixe (T) par rapport audit signal d'entrée (e₀) et un circuit de combinaison (C) à deux entrées (X, Y) recevant respectivement ledit signal d'entrée (e₀) et ledit signal retardé (e₁) et comportant une entrée de commande (CD) recevant une grandeur de commande (K) représentative de ladite consigne (CN), ledit circuit de combinaison étant conçu de façon à fournir en sortie un signal de combinaison (f_{K}) résultant de la superposition avec pondération et effet intégral des signaux appliqués sur ses entrées (X, Y), ladite pondération consistant à affecter deux coefficients de pondération à somme constante associés respectivement au signal d'entrée (e₀) et au signal retardé (e₁) dont les valeurs sont fonction de ladite grandeur de commande (K), ledit circuit à retard étant caractérisé en ce
que ledit circuit de combinaison (C) comporte un premier et un second module de charge et décharge (U0, U1) d'une ligne commune (L) commandés respectivement par ledit signal d'entrée (e₀) et ledit signal retardé (e₁), le potentiel de ladite ligne commune (L) constituant la mesure dudit signal de combinaison (f_{K}), en ce que chaque module (U0, U1) comporte un circuit de décharge (DC) et un circuit de charge (PC) comportant chacun des moyens interrupteurs (P0, N0, P1, N1) contrôlant la connexion entre ladite ligne commune (L) et respectivement un premier et un second potentiel d'alimentation (Vss, Vdd) par l'intermédiaire d'une résistance variable (R0, R0*, R1, R1*), la résistance variable (R0, R0*, R1, R1*) des circuits de décharge et de charge (DC, PC) de chaque module (U0, U1) étant commandée de façon à prendre une valeur inversement proportionnelle au coefficient de pondération du signal associé (e₀, e₁) et en ce que les moyens interrupteurs (P0, N0, P1, N1) du circuit de décharge (DC) et du circuit de charge (PC) de chaque module (U0, U1) sont activés respectivement par un premier et un second niveau de tension du signal associé (e₀, e₁) et en ce que ledit circuit de combinaison (C) et/ou ledit circuit à retard fixe (D1) sont dimensionnés de sorte que ledit retard fixe (T) soit inférieur au temps de transition (tₘ) que présente le signal de combinaison (f_{K}) lorsque le circuit de combinaison (C) reçoit seulement le signal d'entrée (e₀).

2. Circuit à retard selon la revendication 1 caractérisé en ce que ledit circuit à retard fixe (D1) est un amplificateur différentiel réalisé en technologie ECL.

3. Circuit à retard selon la revendication 1 caractérisé en ce que les résistances variables (R0, R0*, R1, R1*) de chaque module (U0, U1) sont réalisées au moyen d'une pluralité de résistances élémentaires pouvant être branchées sélectivement en parallèle en fonction du coefficient de pondération du signal associé (e₀, e₁) audit module (U0, U1).

4. Circuit à retard selon la revendication 3 caractérisé en ce que lesdites résistances (R0, R0*, R1, R1*) et lesdits interrupteurs (P0, N0, P1, N1) sont formés par les chemins drain-source de transistors MOS dont les grilles sont commandées respectivement en fonction desdits coefficients de pondération et par lesdits signaux associés (e₀, e₁).

5. Circuit à retard selon la revendication 4 caractérisé en ce que les transistors MOS reliant ladite ligne commune (L) auxdits potentiels d'alimentation (Vdd, Vss) respectivement haut et bas sont respectivement des transistors à canal p et n.

6. Circuit à retard selon la revendication 5 caractérisé en ce que ledit circuit à retard fixe (D1) est réalisé au moyen de circuits inverseurs réalisés en technologie CMOS.

## Patentansprüche

1. Verzögerungsschaltung zum Liefern eines Ausgangssignals (s_{K}), das in bezug auf ein logisches Eingangssignal (e₀) eine Verzögerung (θ) aufweist, die in Abhängigkeit von einem Verzögerungssollwert (CN) einstellbar ist, wobei die Schaltung eine Schaltung mit fester Verzögerung (D1), die das Eingangssignal (e₀) empfängt und ein verzögertes Signal (e₁) liefert, das in bezug auf das Eingangssignal (e₀) eine feste Verzögerung (T) aufweist, sowie eine Kombinationsschaltung (C) enthält, die zwei Eingänge (X, Y), die das Eingangssignal (e₀) bzw. das verzögerte Signal (e₁) empfangen, sowie einen Steuereingang (CD) enthält, der eine den Sollwert (CN) repräsentierende Steuergröße (K) empfängt, wobei die Kombinationsschaltung so beschaffen ist, daß sie an ihrem Ausgang ein Kombinationssignal (f_{K}) liefert, das sich aus der Überlagerung mit Gewichtung und Integralwirkung der an ihre Eingänge (X, Y) angelegten Signale ergibt, wobei die Gewichtung darin besteht, zum Eingangssignal (e₀) bzw. zum verzögerten Signal (e₁) zwei Gewichtungskoeffizienten mit konstanter Summe hinzuzufügen, deren Werte von der Steuergröße (K) abhängen, wobei die Verzögerungsschaltung dadurch gekennzeichnet ist,
daß die Kombinationsschaltung (C) einen ersten und einen zweiten Modul (U0, U1) zum Laden und Entladen einer gemeinsamen Leitung (L) enthält, die durch das Eingangssignal (e₀) bzw. durch das verzögerte Signal (e₁) gesteuert werden, wobei das Potential der gemeinsamen Leitung (L) das Maß des Kombinationssignals (f_{K}) bildet, daß jeder Modul (U0, U1) eine Entladeschaltung (DC) und eine Ladeschaltung (PC) enthält, die jeweils Ein/Aus-Schaltermittel (P0, N0, P1, N1) enthalten, die die Verbindung zwischen der gemeinsamen Leitung (L) und einem ersten bzw. einem zweiten Versorgungspotential (Vss, Vdd) über einen variablen Widerstand (R0, R0*, R1, R1*) steuern, wobei der variable Widerstand (R0, R0*, R1, R1*) der Entlade- und Ladeschaltungen (DC, PC) jedes Moduls (U0, U1) in der Weise gesteuert wird, daß er einen zum Gewichtungskoeffizienten des zugeordneten Signals (e₀, e₁) umgekehrt proportionalen Wert annimmt, daß die Ein/Aus-Schaltermittel (P0, N0, P1, N1) der Entladeschaltung (DC) und der Ladeschaltung (PC) jedes Moduls (U0, U1) durch einen ersten bzw. einen zweiten Spannungspegel des zugeordneten Signals (e₀, e₁) aktiviert werden und daß die Kombinationsschaltung (C) und/oder die Schaltung mit fester Verzögerung (D1) so dimensioniert sind, daß die feste Verzögerung (T) kleiner als die Flankenzeit (tₘ) ist, die das Kombinationssignal (f_{K}) aufweist, wenn die Kombinationsschaltung (C) nur das Eingangssignal (e₀) empfängt.

2. Verzögerungsschaltung nach Anspruch 1, dadurch gekennzeichnet, daß die Schaltung mit fester Verzögerung (D1) ein in ECL-Technologie verwirklichter Differenzverstärker ist.

3. Verzögerungsschaltung nach Anspruch 1, dadurch gekennzeichnet, daß die variablen Widerstände (R0, R0*, R1, R1*) jedes Moduls (U0, U1) mittels mehrerer elementarer Widerstände verwirklicht sind, die in Abhängigkeit vom Gewichtungskoeffizienten des dem Modul (U0, U1) zugeordneten Signals (e₀, e₁) wahlweise parallelgeschaltet werden können.

4. Verzögerungsschaltung nach Anspruch 3, dadurch gekennzeichnet, daß die Widerstände (R0, R0*, R1, R1*) und die Ein/Aus-Schalter (P0, N0, P1, N1) durch die Drain-Source-Pfade von MOS-Transistoren gebildet sind, deren Gates in Abhängigkeit von den Gewichtungskoeffizenten bzw. von den zugeordneten Signalen (e₀, e₁) gesteuert werden.

5. Verzögerungsschaltung nach Anspruch 4, dadurch gekennzeichnet, daß die MOS-Transistoren, die die gemeinsame Leitung (L) mit dem hohen bzw. dem niedrigen Versorgungspotential (Vdd, Vss) verbinden, p-Kanal-Transistoren bzw. n-Kanal-Transistoren sind.

6. Verzögerungsschaltung nach Anspruch 5, dadurch gekennzeichnet, daß die Schaltung mit fester Verzögerung (D1) mittels Invertiererschaltungen verwirklicht ist, die in CMOS-Technologie verwirklicht sind.

## Claims

1. A delay circuit for supplying an output signal (S_{K}) having a delay (θ) relative to an input logic signal (e₀), said delay (θ) being adjustable as a function of a delay instruction (CN), said circuit comprising a fixed-delay circuit (D1) receiving said input signal (e₀) and supplying a delayed signal (e₁) having a fixed delay (T) relative to said input signal (e₀) and a combination circuit (C) with two inputs (X, Y) receiving respectively said input signal (e₀) and said delayed signal (e₁) and comprising a control input (CD) receiving a control variable (K) representative of said instruction (CN), said combination circuit being designed so as to supply as an output a combination signal (f_{K}) resulting from the superimposition with weighting and integration of the signals applied to its inputs (X, Y), said weighting consisting in assigning two constant-sum weighting coefficients associated respectively with the input signal (e₀) and the delayed signal (e₁), the values of which are a function of said control variable (K), said delay circuit being characterised in that
said combination circuit (C) comprises a first and a second module (U0, U1) for charging and discharging a common line (L), said modules being controlled respectively by said input signal (e₀) and said delayed signal (e₁), the potential of said common line (L) constituting the measurement of said combination signal (fₖ), in that each module (U0, U1) comprises a discharging circuit (DC) and a charging circuit (PC) each comprising switching means (P0, N0, P1, N1) controlling the connection between said common line (L) and, respectively, a first and a second supply potential (Vss, Vdd) via a variable resistor (R0, R0*, R1, R1*), the variable resistor (R0, R0*, R1, R1*) of the discharging and charging circuits (DC, PC) of each module (U0, U1) being controlled so as to take a value that is inversely proportional to the weighting coefficient of the associated signal (e₀, e₁) and in that the switching means (P0, N0, P1, N1) of the discharging circuit (DC) and of the charging circuit (PC) of each module (U0, U1) are activated respectively by a first and a second voltage level of the associated signal (e₀, e₁) and in that said combination circuit (C) and/or said fixed-delay circuit (D1) have dimensions such that said fixed delay (T) is less than the transition time (tₘ) that the combination signal (fₖ) has when the combination circuit (C) receives only the input signal (e₀).

2. A delay circuit according to Claim 1 characterised in that said fixed-delay circuit (D1) is a differential amplifier made in ECL technology.

3. A delay circuit according to Claim 1 characterised in that the variable resistors (R0, R0*, R1, R1*) of each module (U0, U1) are produced by means of a plurality of elementary resistors that can be connected selectively in parallel as a function of the weighting coefficient of the signal (e₀, e₁) associated with said module (U0, U1).

4. A delay circuit according to Claim 3 characterised in that said resistors (R0, R0*, R1, R1*) and said switches (P0, N0, P1, N1) are formed by the drain-source paths of MOS transistors, the gates of which are controlled respectively as a function of said weighting coefficients and by said associated signals (e₀, e₁).

5. A delay circuit according to Claim 4 characterised in that the MOS transistors connecting said common line (L) to said supply potentials (Vdd, Vss), high and low respectively, are p-channel and n-channel transistors respectively.

6. A delay circuit according to Claim 5 characterised in that said fixed-delay circuit (D1) is produced by means of inverter circuits made in CMOS technology.
